# EUROPÄISCHE PATENTANMELDUNG

(11) **EP 1 903 621 A2**
(43) Veröffentlichungstag der Anmeldung: **26.03.2008**
(21) Anmeldenummer: 07018311.6
(22) Anmeldetag: 18.09.2007
(51) Int. Cl.: H01L 41/107

(54) **Piezotransformator**

(30) Priorität: 20.09.2006 DE 102006044184
(71) Anmelder: EPCOS AG, 81669 München (DE)
(72) Erfinder: Florian, Heinz, 8524 Bad Gams (AT); Glazunov, Alexander, Dr., 8530 Deutschlandsberg (AT); Kartashev, Igor, Dr., 8530 Deutschlandsberg (AT)
(74) Vertreter: Epping - Hermann - Fischer

(57) **Zusammenfassung**

Es wird ein Piezotransformator mit einem Körper angegeben, der einen Eingangsteil (1), einen Ausgangsteil (2) und ein zwischen diesen angeordnetes Isolierteil (3) umfasst. Das Isolierteil (3) enthält ein Keramikmaterial, das sich bezüglich der Keramikstruktur vom Material des Ein- und Ausgangsteils (1, 2) unterscheidet. Dieses Material ist vorzugsweise nicht piezoelektrisch.

## Beschreibung

Ein Piezotransformator ist aus der Druckschrift JP 2000-091660 A und US 6,346,764 B1 bekannt.

Eine zu lösende Aufgabe besteht darin, einen Piezotransformator anzugeben, der kostengünstig hergestellt werden kann.

Es wird ein Piezotransformator mit einem Körper angegeben, der einen Eingangsteil, einen Ausgangsteil und ein zwischen diesen angeordnetes Isolierteil umfasst. Das Isolierteil enthält ein Keramikmaterial, das sich bezüglich der Keramikstruktur vom Material des Ein- und Ausgangsteils unterscheidet. Dieses Material ist vorzugsweise nicht piezoelektrisch. Der Eingangsteil, das Isolierteil und der Ausgangsteil sind alle gemeinsam gesintert.

Der thermische Ausdehnungskoeffizient des Materials des Isolierteils ist vorzugsweise demjenigen des Materials des Ein- und Ausgangsteils im Wesentlichen gleich.

Der Ein- und Ausgangsteil des Transformators enthält vorzugsweise eine piezoelektrische Keramik.

Als Keramikmaterial für das Isolierteil kann eine (im Vergleich zur Keramik des Ein- und Ausgangsteils) kostengünstige technische Keramik verwendet werden, die sich durch eine hohe Durchschlagfestigkeit auszeichnet.

Der Transformator nutzt sowohl den direkten als auch den inversen piezoelektrischen Effekt. Unter dem direkten piezoelektrischen Effekt wird verstanden, dass in dem Grundkörper bei Auftreten von Verformungen eine Spannung abfällt. Es wird unter dem inversen piezoelektrischen Effekt verstanden, dass die piezoelektrische Keramik, die gegebenenfalls zum Einsatz des Bauelementes noch polarisiert werden muss, bei Anlegen eines elektrischen Feldes parallel oder antiparallel oder auch in einem Winkel zur Polarisierungsrichtung eine Verformung erfährt.

Der Ein- und Ausgangsteil sind vorzugsweise mechanisch aneinander gekoppelt und galvanisch voneinander getrennt. Die galvanische Trennung der beiden Teile ist durch das Isolierteil erreichbar.

Die Durchschlagsspannung des Isolierteils ist vorzugsweise größer als diejenige des Ein- und Ausgangsteils. Die Durchschlagsspannung des Isolierteils ist vorzugsweise um mindestens das Dreifache größer als diejenige des Ein- und Ausgangsteils. In diesem Fall kann die Dicke des Isolierteils besonders klein gewählt werden.

Ein elektrisches Eingangssignal wird im Eingangsteil des piezoelektrischen Transformators in mechanische Schwingungen des Grundkörpers des Transformators umgewandelt. Aufgrund der mechanischen Kopplung des Eingangsteils und des Ausgangsteils sind beide Teile von der mechanischen Schwingung betroffen. Die Umwandlung der elektrischen Energie in die mechanische Energie erfolgt aufgrund des inversen piezoelektrischen Effekts. Im Ausgangsteil werden die mechanischen Schwingungen aufgrund des direkten piezoelektrischen Effekts zurück in ein elektrisches Signal verwandelt.

Im Grundkörper können vorteilhafterweise dem Eingangsteil zugeordnete Eingangselektroden und dem Ausgangsteil zugeordnete Ausgangselektroden vorgesehen sein. Mit Hilfe der Eingangselektroden kann bei Anlegen einer Spannung an den Eingangselektroden eine mechanische Verformung des Grundkörpers hervorgerufen werden. Mit Hilfe der Ausgangselektroden kann eine bei Verformung des Körpers auftretende elektrische Spannung abgegriffen werden.

Beim Anlegen einer Wechselspannung an den Eingangselektroden kann eine periodisch wiederkehrende Deformation des Körpers erzeugt werden. Diese periodisch wiederkehrende Deformation des Körpers kann wiederum in den Ausgangselektroden eine sich periodisch ändernde Spannung hervorrufen. Durch geeignete Anordnung der Elektroden kann erreicht werden, dass die Ausgangsspannung von der Eingangsspannung verschieden ist. In diesem Fall erhält man einen Transformator mit einem dem Verhältnis der Spannungen entsprechenden Übersetzungsverhältnis.

Das Keramikmaterial des Isolierteils umfasst vorzugsweise eine LTCC. LTCC steht für Low Temperature Cofired Ceramics. Das Isolierteil kann insbesondere Al₂O₃ und/oder A1N als Grundmaterial enthalten.

Der Eingangsteil und der Ausgangsteil werden vorzugsweise jeweils durch Laminieren von keramischen Grünschichten erzeugt. Diese Schichten umfassen vorzugsweise ein Blei-Zirkonat-Titanat (PZT) oder ein anderes Material mit piezoelektrischen Eigenschaften. Das Isolierteil, das mindestens eine Keramikschicht aufweist, wird vorzugsweise auf den Eingangsteil (oder Ausgangsteil) vor der Erzeugung des Ausgangsteils (bzw. Eingansteils) aufgebracht.

Alle Teile des Körpers werden vorzugsweise in einem Laminierverfahren erzeugt.

Das Isolierteil kann neben dem Grundmaterial Additive enthalten, die beispielsweise dazu dienen, die Sintertemperatur vom Grundmaterial des Isolierteils, z. B. Aluminiumoxid, an diejenige der Piezokeramik des Ein- und Ausgangsteils anzupassen. Als Additive kommen insbesondere Oxide oder eine Mischung aus mehreren Oxiden in Betracht. Das Isolierteil kann SiO₂ oder einen Glasanteil enthalten. Die Sintertemperatur der LTCC-Keramik, die Aluminiumoxid enthält, kann durch Glaszusätze beispielsweise auf 400°C bis 600°C reduziert werden.

Der Eingangsteil kann Eingangselektroden und der Ausgangsteil Ausgangselektroden umfassen, die zumindest teilweise senkrecht zur Längsachse des Körpers angeordnet sind.

Der Eingangsteil kann innen liegende Eingangselektroden und der Ausgangsteil innen liegende Ausgangselektroden umfassen, die senkrecht zur Längsachse des Körpers angeordnet sind. Alle innen liegenden Eingangselektroden sind an eine außen liegende Eingangselektrode und alle innen liegenden Ausgangselektroden sind an eine außen liegende Ausgangselektrode angeschlossen. Die außen liegenden Elektroden sind jeweils zumindest teilweise an der Oberfläche des Körpers angeordnet.

In einer vorteilhaften Variante weist das Isolierteil eine innen liegende Hilfselektrode, die parallel zu den innen liegenden Ein- und Ausgangselektroden angeordnet ist.

Die Hilfselektrode hat in einer Variante keine galvanische Verbindung zum Ein- oder Ausgangsteil innerhalb des Körpers. Sie kann aber auch innerhalb des Körpers mit einer Elektrode des Eingangsteils oder Ausgangsteils galvanisch verbunden sein.

Der angegebene Piezotransformator wird nun anhand von schematischen und nicht maßstabgetreuen Figuren erläutert. Es zeigen:
Figur 1 einen Piezotransformator mit einem Eingangsteil, Isolierteil und Ausgangsteil, die alle gemeinsam gesintert sind;
Figur 2 einen weiteren Piezotransformator, dessen Isolierteil eine Hilfselektrode aufweist.

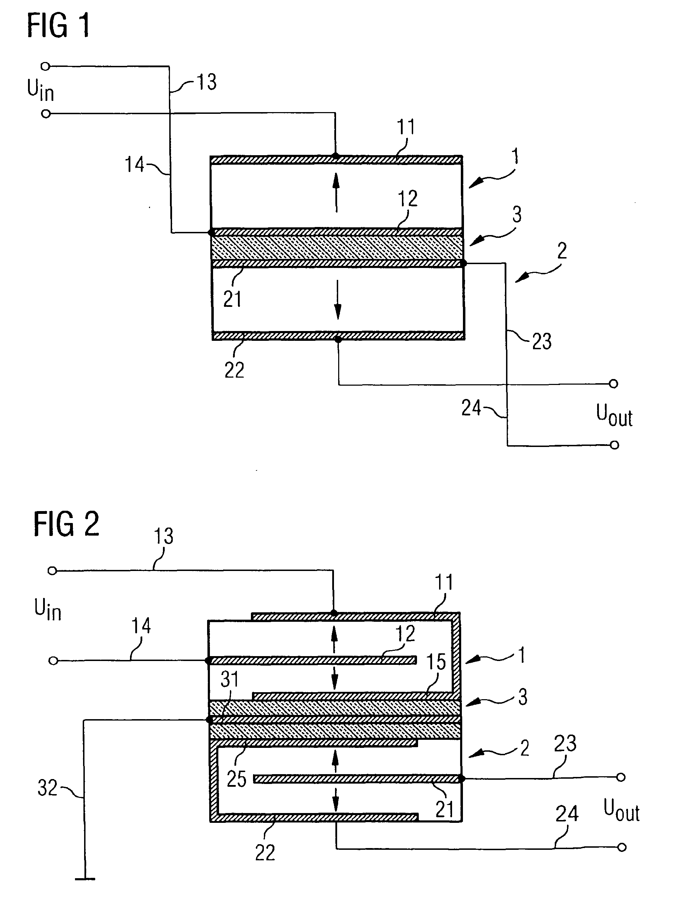

In den Figuren 1, 2 ist jeweils ein piezoelektrischer Transformator gezeigt. Der Transformatorkörper umfasst einen Eingangteil 1, einen Ausgangsteil 2 und ein dazwischen angeordnetes Isolierteil 3. Der Eingangteil sowie der Ausgangteil umfasst jeweils mindestens eine Piezoschicht, die zwischen zwei Elektroden des jeweiligen Teils angeordnet ist. Die Polarisationsrichtung der jeweiligen Piezoschicht ist in den Figuren 1, 2 mit einem Pfeil angedeutet. Die Polarisationsachse der jeweiligen Piezoschicht ist senkrecht zu den Flächen der Elektroden 11, 12, 21, 22 des Ein- und Ausgangsteils 1, 2 sowie senkrecht zu den Stirnflächen des Körpers ausgerichtet.

Der Eingangteil 1 weist mindestens eine erste Eingangselektrode 11, 15 sowie mindestens eine zweite Eingangselektrode 12 auf. Der Ausgangteil 2 weist mindestens eine erste Ausgangselektrode 21, 25 sowie mindestens eine zweite Ausgangselektrode 22 auf. Einige dieser Elektroden, z. B. die Elektroden 12, 15 und 22, 25, sind im Körperinneren angeordnet.

In der Variante gemäß der Figur 1 ist nur eine erste Eingangselektrode und eine zweite Eingangselektrode sowie nur eine erste Ausgangselektrode und eine zweite Ausgangselektrode vorgesehen. In der Variante gemäß der Figur 2 ist angedeutet, dass zumindest eine Elektrodensorte des jeweiligen Transformatorteils mehrere leitend miteinander verbundene erste und/oder mehrere leitend miteinander verbundene zweite Elektroden umfassen kann.

Obwohl in der Figur 2 pro Transformatorteil (Ein- und Ausgangsteil) der Einfachheit halber nur zwei Piezoschichten gezeigt sind, sind im jeweiligen Transformatorteil in der Regel mehr als nur zwei Piezoschichten und auch eine Vielzahl von Elektroden jeder Sorte vorgesehen.

Alle ersten Eingangselektroden sind an eine gemeinsame Sammelschiene angeschlossen, die mit einem ersten elektrischen Anschluss 13 verbindbar ist. Alle zweiten Eingangselektroden sind auch an eine gemeinsame Sammelschiene angeschlossen, die mit einem zweiten elektrischen Anschluss 14 verbindbar ist. Alle ersten Ausgangselektroden sind an einer gemeinsamen Sammelschiene angeschlossen, die mit einem dritten elektrischen Anschluss 23 verbindbar ist. Alle zweiten Ausgangselektroden sind an einer gemeinsamen Sammelschiene angeschlossen, die mit einem vierten elektrischen Anschluss 24 verbindbar ist. Die elektrischen Anschlüsse 13, 14 verbinden den Eingangsteil mit einer Signalquelle, d. h. einer Eingangsspannung Uᵢₙ. Die elektrischen Anschlüsse 23, 24 verbinden den Ausgangsteil mit einer elektrischen Last, die die Ausgangsspannung Uₒᵤₜ des Transformators abgreift.

Die Elektroden 11 und 21 sind an den Stirnseiten des Körpers angeordnet. Einige der Elektroden - wie z. B. die Elektroden 12, 15, 22, 25 - können im Inneren des Körpers angeordnet sein.

In der Variante gemäß der Figur 2 ist mindestens eine Hilfselektrode 31 vorgesehen, die zumindest teilweise im Inneren des Isolierteils 3 angeordnet ist. Die Hilfselektrode 31 ist parallel zu den Elektroden 11, 12, 15, 21, 22, 25 des Eingangsteil 1 und des Ausgangsteils 2 angeordnet. Die Hilfselektrode 31 ist vorzugsweise zwischen zwei gleichartigen Keramikschichten des Isolierteils angeordnet.

Die Hilfselektrode 31 kann mittels einer z. B. außerhalb des Körpers liegenden Masseverbindung 32 (z. B. Draht) mit Masse verbunden sein, die vorzugsweise von den Elektroden des Ein- und Ausgangsteils galvanisch entkoppelt ist. Die Hilfselektrode 31 kann aber auch mit einer Elektrode des Ein- oder Ausgangsteil leitend verbunden sein. Die Hilfselektrode 31 kann in einer Variante floatend bleiben.

Mit der Hilfselektrode 31 gelingt es, den Eingangsteil von Ausgangsteil abzuschirmen und der Übertragung von Störsignalen zwischen den Transformatorteilen vorzubeugen.

### Bezugszeichenliste

- 1: Eingangsteil
- 11: Eingangselektrode
- 12, 15: innen liegende Eingangselektroden
- 13, 14: elektrische Anschlüsse
- 2: Ausgangsteil
- 21: Ausgangselektrode
- 22, 25: innen liegende Ausgangselektroden
- 23, 2: 4 elektrische Anschlüsse
- 3: Isolierteil
- 31: Hilfselektrode
- 32: Masseverbindung
- Uᵢₙ: Eingangsspannung
- Uₒᵤₜ: Ausgangsspannung

## Patentansprüche

1. Piezotransformator
- mit einem Körper, der einen Eingangsteil (1), einen Ausgangsteil (2) und ein zwischen diesen angeordnetes Isolierteil (3) umfasst,
- wobei das Isolierteil (3) ein Keramikmaterial umfasst, das sich bezüglich der Keramikstruktur vom Material des Ein- und Ausgangsteils (1, 2) unterscheidet,
- wobei der Eingangsteil (1), der Ausgangsteil (2) und das Isolierteil (3) gemeinsam gesintert sind.

2. Piezotransformator nach Anspruch 1,
- wobei das Isolierteil (3) nicht piezoelektrisch ist.

3. Piezotransformator nach Anspruch 1 oder 2,
- wobei das Keramikmaterial des Isolierteils (3) eine Low Temperature Cofired Ceramics enthält.

4. Piezotransformator nach einem der Ansprüche 1 bis 3,
- wobei das Isolierteil (3) Glas enthält.

5. Piezotransformator nach einem der Ansprüche 1 bis 4,
- wobei der Eingangsteil (1) innen liegende Eingangselektroden (12, 15) und der Ausgangsteil innen liegende Ausgangselektroden (22, 25) umfasst, die senkrecht zur Längsachse des Körpers angeordnet sind.

6. Piezotransformator nach einem der Ansprüche 1 bis 5,
- wobei im Isolierteil (3) mindestens eine Hilfselektrode (31) angeordnet ist, die parallel zu den innen liegenden Ein- und Ausgangselektroden (12, 15, 22, 25) angeordnet ist.

7. Piezotransformator nach Anspruch 6,
- wobei die Hilfselektrode (31) innerhalb des Körpers keine galvanische Verbindung zu den Elektroden des Ein- oder Ausgangsteils hat.

8. Piezotransformator nach Anspruch 6,
- wobei die Hilfselektrode (31) mit einer Elektrode des Eingangsteils oder Ausgangsteils innerhalb des Körpers galvanisch verbunden ist.

9. Piezotransformator nach einem der Ansprüche 1 bis 8,
- wobei die Durchschlagsspannung des Isolierteils (3) größer als diejenige des Ein- und Ausgangsteils (1, 2) ist.

10. Piezotransformator nach einem der Ansprüche 1 bis 8,
- wobei das Isolierteil Al₂O₃ oder A1N enthält.
